# EUROPÄISCHE PATENTSCHRIFT

(11) **EP 2 053 654 B1**
(45) Veröffentlichungstag und Bekanntmachung des Hinweises auf die Patenterteilung: **23.03.2016**
(21) Anmeldenummer: 08012605.5
(22) Anmeldetag: 11.07.2008
(51) Int. Cl.: H01L 23/367, H05K 1/02

(54) **Gekühltes Multichipmodul**
Cooled multichip module
Module multi-puces refroidi

(30) Priorität: 22.10.2007 DE 102007050432; 22.11.2007 DE 102007056269
(43) Veröffentlichungstag der Anmeldung: 29.04.2009
(73) Patentinhaber: Rohde & Schwarz GmbH & Co. KG, 81671 München (DE)
(72) Erfinder: Kahmen, Gerhard, 82041 Deisenhofen (DE)
(74) Vertreter: Körfer, Thomas

(56) Entgegenhaltungen:
- EP-A- 1 796 444
- WO-A-2005/001943
- WO-A-2006/032219
- DE-A1- 10 035 170
- US-A- 5 724 232
- US-A- 5 796 165
- US-A- 5 814 883
- US-A- 5 923 084
- US-A1- 2002 084 524
- US-A1- 2003 128 522
- US-A1- 2003 169 575
- US-A1- 2003 214 049
- US-A1- 2004 120 121
- US-A1- 2004 212 073

## Beschreibung

Die Erfindung betrifft eine elektronische Schaltungsanordnung gemäß dem Oberbegriff des Anspruches 1.

Herkömmlich werden Mikrochips, welche in Modulen, insbesondere keramischen Modulen montiert sind, durch Ableitung der Wärme an der Moduloberfläche bzw. an der Rückseite der Trägerplatine gekühlt. Dabei verteilt sich die im Mikrochip entstehende Wärme in dem Modul und in der Trägerplatine, bis sie abgeleitet wird. Eine thermische Verbindung zu der Trägerplatine bzw. der Trägerplatinenrückseite erfordert eine rückseitige Kühlung und damit eine Montage von Bauteilen auf der Trägerplatinenrückseite, was zum einen die Herstellung deutlich aufwändiger gestaltet, und andererseits die Flexibilität der weiteren Verwendung deutlich einschränkt.

So wird in der DE 103 36 171 A1 ein Multi-Chip-Schaltungsmodul gezeigt, welches über die Trägerplatine gekühlt wird. Dabei findet keine gezielte Wärmeleitung statt. Die Wärme wird über die Trägerplatinenrückseite abgeführt. Dies sorgt einerseits für eine nur geringe Wärmeabführung, was für eine Vielzahl von Anwendungen nicht ausreichend ist, zum anderen wird durch die fehlende Wärmeleitung das Multi-Chip-Modul aufgeheizt, was die Lebensdauer der Komponenten reduziert und gleichzeitig das thermische Design des Gesamtgeräts erschwert. Ein Einsatz bestimmter Komponenten ist bei zu starker Erwärmung nur unter reduzierter Leistung bzw. generell nicht möglich.

In der US 2003/0169575 A1 ist eine elektronische Schaltungsanordnung in zwei Varianten beschrieben. Bei beiden Varianten (Figuren 7 und 8) ist ein mehrlagiges Substrat auf einer Trägerplatine angeordnet, welches ein Wärme abstrahlendes Bauelement trägt. Letzteres ist bei der ersten Variante (Figur 7) in einer an der Unterseite des Substrats vorgesehenen Ausnehmung angeordnet, während es bei der zweiten Variante (Figur 8) in einer an der Oberseite des Substrats vorgesehenen Ausnehmung angeordnet ist. In beiden Fällen wird die von dem Bauelement erzeugte Wärme auf die Trägerplatine abgeleitet. Bei der ersten Variante wird die Wärme von dem unten gelegenen Bauelement über ein zwischen dem Bauelement und der Trägerplatine gelegenes plattenförmiges Dichtungselement auf die Trägerplatine abgeleitet. Bei der zweiten Variante sind das Substrat durchgreifende Durchkontaktierungen vorgesehen, welche die Wärme von dem oben gelegenen Bauelement auf die Trägerplatine leiten.

Der Erfindung liegt die Aufgabe zugrunde eine Schaltungsanordnung der eingangs beschriebenen Art so zu gestalten, dass sie einerseits eine kompakte Bauweise erlaubt und anderseits mit der von dem zumindest einen Bauelement abzuführende Wärme die Trägerplatine so wenig wie möglich zu belasten.

Die Aufgabe wird erfindungsgemäß durch die Merkmale des unabhängigen Anspruchs 1 gelöst. Vorteilhafte Weiterbildungen sind Gegenstand der hierauf rückbezogenen Unteransprüche.

Eine elektronische Schaltungsanordnung besteht aus zumindest einem Wärme abstrahlenden Bauelement, einem mehrlagigen Substrat, und zumindest einer thermischen Durchkontaktierung durch das mehrlagige Substrat. Das Wärme abstrahlende Bauelement ist an der Unterseite des mehrlagigen Substrats montiert und mittels der zumindest einen thermischen Durchkontaktierung mit der Oberseite des mehrlagigen Substrats verbunden. Das Wärme abstrahlende Bauelement wird mittels der zumindest einen thermischen Durchkontaktierung durch das mehrlagige Substrat gekühlt. Damit ist eine effektive Kühlung durch einen sehr kurzen thermischen Weg bis zum Kühlkörper gewährleistet. Weiterhin ist eine Bestückung der Rückseite der Trägerplatine mit Bauteilen zur Kühlung nicht notwendig, was eine große Flexibilität des Einsatzes ermöglicht und einen geringen Platzbedarf zur Folge hat.

Vorteilhafterweise ist das Wärme abstrahlende Bauelement ein Mikrochip. So können die besonders stark Wärme abstrahlenden Mikrochips effizient gekühlt werden.

Das Wärme abstrahlende Bauelement ist bevorzugt mittels mehrerer thermischer Durchkontaktierung durch das mehrlagige Substrat mit der Oberseite des mehrlagigen Substrats verbunden. Zumindest eine der mehreren thermischen Durchkontaktierungen ist bevorzugt nicht durch sämtliche Lagen des mehrlagigen Substrats geführt. Die Verteilung der mehreren thermischen Durchkontaktierungen in ihrer Position und in der Anzahl an Lagen des mehrlagigen Substrats, durch welche die mehreren thermischen Durchkontaktierungen geführt sind, bilden bevorzugt die Verbreitungscharakteristik der, von dem Wärme abstrahlenden Bauelement abgestrahlten Wärme nach. Die Durchkontaktierungen sind senkrecht zu der Wärmeausbreitungsrichtung im Substrat angeordnet. So wird eine laterale Ausbreitung der Wärme im Substrat vermieden und eine noch effizientere Wärmeableitung bei gleichzeitiger Einsparung von Fläche auf den Lagen des mehrlagigen Substrats ist gegeben.

Vorteilhafterweise ist das mehrlagige Substrat durch mehrere Lagen eines keramischen Werkstoffs oder einer mehrlagigen Leiterplatte gebildet. So ist die Anwendbarkeit der Erfindung in einem breiten technologischen Bereich gegeben.

Auf der Oberseite des mehrlagigen Substrats ist vorteilhafterweise zumindest ein oberflächenmontiertes Bauelement (Surface Mounted Device) montiert. So ist eine sehr weit integrierte Bauweise der Schaltung möglich, was einen sehr geringen Platzbedarf zur Folge hat. Vorteilhafterweise weist zumindest eine Lage des mehrlagigen Substrats zumindest eine Aussparung auf, in welcher bevorzugt das zumindest eine Wärme abstrahlende Bauelement montiert ist. Dies verringert den Platzbedarf weiter und erhöht die thermische Kopplung des Wärme abstrahlenden Bauelements an das Substrat. Weiterhin ist eine kürzere elektrische Anbindung möglich. Ein mechanischer Schutz wird zusätzlich erreicht.

Vorteilhafterweise verfügt das zumindest eine Wärme abstrahlende Bauelement über eine metallisierte Fläche zur Anbindung an die zumindest eine thermische Durchkontaktierung. Damit ist die thermische Kopplung an die thermische Durchverbindung und damit an die Kühlung besonders stark ausgeprägt. Unterschiedliche Temperaturen an verschiedenen Stellen des Wärme abstrahlenden Bauelements werden damit vermieden.

Die Kühlung des zumindest einen Wärme abstrahlenden Bauelements erfolgt auf der Oberseite der elektronischen Schaltungsanordnung mittels zumindest eines Kühlelements, wobei das Kühlelement ein Kühlkörper und/oder ein Kühlblech und/oder ein Schirmdeckel und/oder ein Luftstrom ist. So ist eine effektive Kühlung gewährleistet. Durch die Kühlung nur auf der Oberseite wird die Unterseite des Substrats nicht mit Bauteilen bestückt, was die Flexibilität des Einbaus in Geräte deutlich erhöht, den Einsatz von einer Kugelgitteranordnung (Ball Grid Array) oder Flächengitteranordnung (Land Gris Array) zur Kontaktierung ermöglicht und den Platzbedarf reduziert.

Die Verbindung der zumindest einen thermischen Durchkontaktierung zu dem zumindest einen Kühlelement erfolgt bevorzugt durch Wärmeleitpaste und/oder Wärmematten und/oder durch direkten Kontakt und/oder durch eine feste Verbindung durch Löten und/oder durch eine feste Verbindung durch Kleben und/oder durch Aufpressen und/oder durch Schrauben. Damit ist eine ideale thermische Kopplung gewährleistet.

Die Verbindung der zumindest einen thermischen Durchkontaktierung zu dem zumindest einen Kühlelement erfolgt bevorzugt durch zumindest einen Abstandshalter, welcher eine kleinere Fläche aufweist als das Kühlelement. Die Verbindung des Abstandshalters an das Kühlelement erfolgt bevorzugt durch Wärmeleitpaste und/oder Wärmematten und/oder durch direkten Kontakt und/oder durch eine feste Verbindung durch Löten und/oder durch eine feste Verbindung durch Kleben und/oder durch Aufpressen und/oder durch Schrauben und/oder durch Fertigung aus einem gemeinsamen Werkstück. Die Verbindung der zumindest einen thermischen Durchkontaktierung zu dem zumindest einen Abstandshalter erfolgt bevorzugt durch Wärmeleitpaste und/oder Wärmematten und/oder durch direkten Kontakt und/oder durch eine feste Verbindung durch Löten und/oder durch eine feste Verbindung durch Kleben und/oder durch Aufpressen und/oder durch Schrauben. So ist zu einen eine sichere und effiziente Wärmeleitung an das Kühlelement gewährleistet. Andererseits wird durch die Nutzung eines Abstandshalters die von dem Kühlelement auf der Substratoberseite verdeckte Fläche reduziert. So können auf der Substratoberfläche bei gleichbleibender Kühlelementgröße zusätzliche Bauelemente verbaut werden. Die Größe der gesamten Schaltungsanordnung kann damit reduziert werden. Durch kürzere Signalpfadlängen ergibt sich zusätzlich ein günstigeres Hochfrequenzverhalten der Schaltungsanordnung. Eine Nutzung von größeren Kühlelementen ist ebenso möglich. Dies erhöht die Flexibilität des Bauelementeinsatzes und kann die Leistungsfähigkeit der Schaltungsanordnung verbessern.

Auf zumindest einer Lage des mehrlagigen Substrats ist bevorzugt zumindest ein planares Bauelement integriert, das z.B. eine Kapazität und/oder ein Widerstand und/oder eine Induktivität und/oder ein Koppler und/oder ein Filter sein kann. So wird der Platzbedarf der gesamten Schaltung durch Erhöhung der Integrationsdichte reduziert.

Vorteilhafterweise sind mehrere Wärme abstrahlende Bauelemente an der Unterseite des mehrlagigen Substrats montiert und mittels mehrerer thermischer Durchkontaktierungen mit der Oberseite des mehrlagigen Substrats verbunden. Die Wärme abstrahlenden Bauelemente werden mittels der thermischen Durchkontaktierungen durch das mehrlagige Substrat gekühlt. Durch den Einsatz einer geringeren Anzahl von Kühlelementen werden der Platzbedarf und die Kosten weiter reduziert, die Signallaufzeiten zwischen den Bauelementen minimiert und das Hochfrequenzverhalten der Schaltung verbessert.

Die elektronische Schaltungsanordnung verfügt bevorzugt über eine Kugelgitteranordnung (Ball Grid Array) oder eine Flächengitteranordnung (Land Grid Array) auf ihrer Unterseite und ist bevorzugt mittels dieser mit einer die elektronische Schaltungsanordnung tragenden Leiterplatte kontaktiert. So ist eine standardisierte Montage möglich und eine sichere Kontaktierung gewährleistet.

Das zumindest eine Wärme abstrahlende Bauelement ist bevorzugt mit seiner Unterseite an der Unterseite des mehrlagigen Substrats befestigt und mittels Bonddrähten auf seiner Oberseite elektrisch an die Unterseite des mehrlagigen Substrats angebunden. Dies reduziert den Platzbedarf und gewährleistet eine sichere elektrische Kontaktierung des Wärme abstrahlenden Bauelements.

Vorteilhafterweise ist das zumindest eine Wärme abstrahlende Bauelement auf der Unterseite der elektronischen Schaltungsanordnung abgedeckt. Dies erhöht die Sicherheit der Montage des Wärme abstrahlenden Bauelements und reduziert die Anforderungen an die Genauigkeit der Montage des mehrlagigen Substrats in Geräten, da das empfindliche Wärme abstrahlende Bauelement geschützt wird. Hermetische Dichtheit gegenüber Umwelteinflüssen kann erreicht werden.

Das zumindest eine Wärme abstrahlende Bauelement ist bevorzugt mit seiner Unterseite an der Unterseite des mehrlagigen Substrats befestigt und mittels einer Kugelgitteranordnung (Ball Grid Array) oder einer Flächengitteranordnung (Land Grid Array) auf seiner Oberseite direkt mit einer, die elektronische Schaltungsanordnung tragenden Leiterplatte kontaktiert. Dies verringert den Aufwand der elektrischen Kontaktierung des Wärme abstrahlenden Bauelements.

Das zumindest eine Wärme abstrahlende Bauelement ist bevorzugt mit seiner Oberseite an der Unterseite des mehrlagigen Substrats befestigt (Flipchip) und mittels Kontaktierhügeln (Bumps) auf seiner Oberseite mit der Unterseite des mehrlagigen Substrats kontaktiert. Dies verringert den Aufwand der elektrischen Kontaktierung des Wärme abstrahlenden Bauelements.

Durch den äußeren Rand des mehrlagigen Substrats sind bevorzugt mehrere elektrische Durchkontaktierungen geführt. Zumindest zwischen zwei Lagen des mehrlagigen Substrats befindet sich bevorzugt zumindest eine metallisierte Massefläche. Die mehreren elektrischen Durchkontaktierungen und die zumindest eine Massefläche bilden bevorzugt eine elektrische Abschirmung. So ist eine wirksame Schirmung der Schaltungsanordnung auch ohne Montage in einem geschirmten Gehäuse gegeben.

Die, die Schaltungsanordnung tragende Leiterplatte beinhaltet bevorzugt auf Höhe des mehrlagigen Substrats eine metallisierte Massefläche, welche eine elektrische Abschirmung bildet. So kann die Schirmung auch ohne Einbau in ein geschirmtes Gehäuse weiter verbessert werden.

Die zumindest eine thermische Durchkontaktierung ist bevorzugt als Aussparung in zumindest einer Lage des mehrlagigen Substrats realisiert. Vorteilhafterweise sind die Seitenflächen der Aussparung mit einem Wärme leitenden Material beschichtet. Bevorzugt ist die Aussparung nicht vollständig mit dem Wärme leitenden Material gefüllt. So kann einerseits eine ausreichende Wärmeleitung erreicht werden. Andererseits stellt die Beschichtung der Seitenflächen eine geringere technische Herausforderung dar, als das Auffüllen der Durchkontaktierungen mit leitfähigem Material.

Bevorzugt ist die zumindest eine thermische Durchkontaktierung als Aussparung in zumindest einer Lage des mehrlagigen Substrats realisiert. Vorteilhafterweise ist die Aussparung vollständig mit dem Wärme leitenden Material gefüllt. Der technische Aufwand, die Durchkontaktierungen vollständig mit leitfähigem Material zu füllen ist erhöht. Jedoch ergibt sich eine sehr gute Wärmeleitung, da der Querschnitt leitenden Materials deutlich vergrößert ist.

Die zumindest eine thermische Durchkontaktierung besteht bevorzugt aus einem elektrisch leitfähigen Material und ist bevorzugt zur Übertragung von elektrischer Spannung bzw. elektrischem Strom eingesetzt. So können die Durchkontaktierungen für zwei getrennte Aufgaben eingesetzt werden. Eigene elektrische Durchkontaktierungen können eingespart werden, was zum einen den Fertigungsaufwand reduziert, und zum Anderen den Platzbedarf der elektrischen Schaltungsanordnung verringert. Schwer oder gar nicht elektrisch zugängliche Bereiche auf der Rückseite des mehrlagigen Substrats können so außerdem mit Spannung versorgt werden.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: eine erste, bislang übliche elektronische Schaltungsanordnung in seitlicher Schnittdarstellung;
- Fig. 2: eine zweite, bislang übliche elektronische Schaltungsanordnung in seitlicher Schnittdarstellung;
- Fig. 3: eine erste beispielhafte erfindungsgemäße elektronische Schaltungsanordnung in seitlicher Schnittdarstellung, und

- Fig. 4: eine zweite beispielhafte erfindungsgemäße elektronische Schaltungsanordnung in seitlicher Schnittdarstellung.

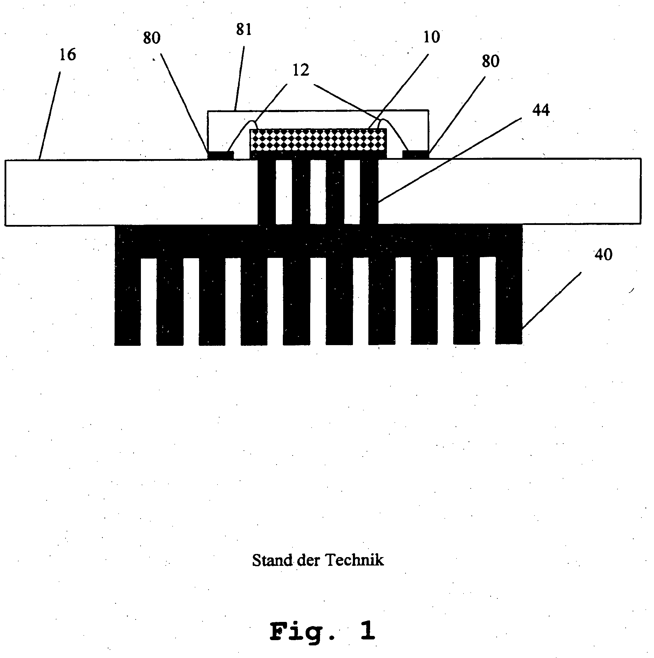

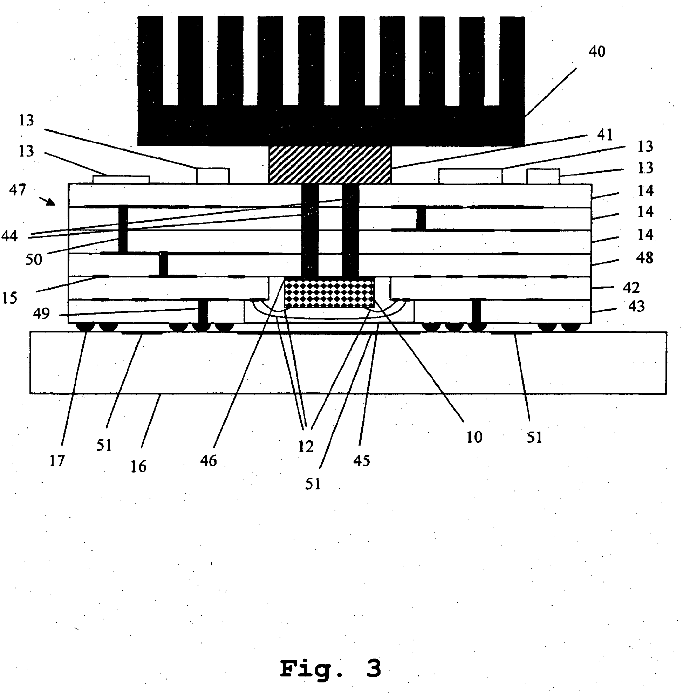

Zunächst wird anhand der Fig. 1 - 2 der Aufbau und die Funktionsweise von bislang üblichen elektronischen Schaltungsanordnungen gezeigt und Probleme ihrer Nutzung erläutert. Mittels Fig. 3 - 4 wird anschließend der Aufbau und die Funktionsweise verschiedener Formen der erfindungsgemäßen elektronischen Schaltungsanordnung veranschaulicht. Identische Elemente wurden in ähnlichen Abbildungen zum Teil nicht wiederholt dargestellt und beschrieben.

In den Figuren sind die Skalierungen der horizontalen und der vertikalen Achsen unterschiedlich. So sind die dargestellten Ausführungsbeispiele in der Realität deutlich weiter in horizontaler Richtung ausgedehnt als der Übersichtlichkeit halber gezeichnet.

In Fig. 1 wird eine erste, bislang übliche elektronische Schaltungsanordnung in seitlicher Schnittdarstellung gezeigt. Auf der Oberfläche einer Trägerplatine 16 ist ein Mikrochip 10 montiert. Der Mikrochip 10 befindet sich in einem geschlossenen Gehäuse 81. Der Mikrochip 10 ist mittels Bonddrähten 12 an Kontakte 80 des Gehäuses 81 angeschlossen. Im Mikrochip 10 entstehende Wärme wird über seine metallisierte Rückseite über thermische Durchkontaktierungen 44 an einen auf der Rückseite der Trägerplatine montierten Kühlkörper 40 geleitet und von diesem abgestrahlt.

Diese Anordnung benötigt eine verhältnismäßig große Bautiefe, da die Rückseite der Trägerplatine 16 mit dem Kühlkörper 40 versehen ist. Weiterhin ist die Montage erschwert, da beide Seiten der Trägerplatine 16 mit Bauteilen bestückt sind. Auf Grund der Dicke der Trägerplatine 16 ist zusätzlich der Wärmeübergang suboptimal.

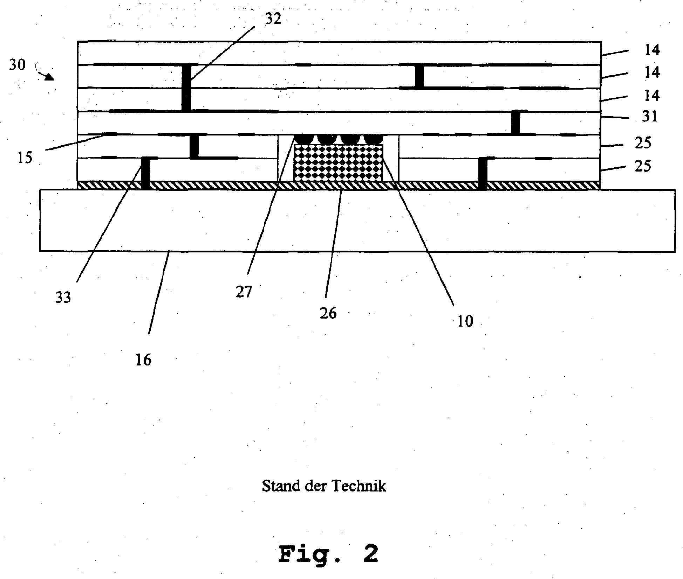

Fig. 2 zeigt eine zweite, bislang übliche elektronische Schaltungsanordnung in seitlicher Schnittdarstellung. Ein mehrschichtiges Substrat 30, hier eine mehrschichtige Keramik, ist aus mehreren Substratschichten 14, 25, 31 zusammengesetzt. Die Substratschichten 25 verfügen über eine Aussparung. In dieser Aussparung ist ein Mikrochip 10 montiert. Der Mikrochip 10 ist mit seiner Oberseite mittels einer Kugelgitteranordnung (Ball Grid Array) 27 an einer Substratschicht 31 elektrisch angeschlossen. Auf den einzelnen Schichten 14, 25, 31 des mehrschichtigen Substrats 30 sind planare Leiterbahnen 15 aufgebracht, welche verschiedene Bauelemente bilden. So sind auch hier z.B. Widerstände, Kapazitäten, Induktivitäten, Filter, Koppler und viele weitere möglich. Die einzelnen Substratschichten 14, 25, 31 sind zum Teil mittels elektrischer Durchverbindungen 32 miteinander verbunden. Das mehrschichtige Substrat 30 ist mittels eines Füllmaterials 26 mit einer, die elektronische Schaltungsanordnung tragenden Leiterplatte 16 verbunden. Somit ist die Aussparung der Substratschichten 25 hermetisch dicht abgeschlossen. Die elektronische Schaltungsanordnung ist mittels Durchkontaktierungen 33 mit der Leiterplatte 16 verbunden. Die hier gezeigte Anordnung verfügt jedoch über geringe Wärmeableitungsfähigkeiten. So verteilt sich im Mikrochip entstehende Wärme sowohl in dem mehrschichtigen Substrat 30 als auch in der Leiterplatte 16. Eine gezielte Wärmeabstrahlung findet nicht statt.

In Fig. 3 wird eine erste beispielhafte erfindungsgemäße elektronische Schaltungsanordnung in seitlicher Schnittdarstellung gezeigt. Ein mehrschichtiges Substrat 47, hier eine mehrschichtige Keramik, besteht aus einzelnen Substratschichten. Auf den einzelnen Schichten 14, 42, 43, 48 des mehrschichtigen Substrats 47 sind planare Leiterbahnen 15 aufgebracht, welche verschiedene Bauelemente bilden. So sind auch hier z.B. Widerstände, Kapazitäten, Induktivitäten, Filter, Koppler und viele weitere möglich. Die einzelnen Substratschichten 14, 42, 43, 48 sind zum Teil mittels elektrischer Durchverbindungen 50 miteinander verbunden. Auf der Oberseite des mehrschichtigen Substrats sind oberflächenmontierte Bauelemente (Surface Mounted Devices) 13 montiert. Einzelne Substratschichten 42, 43 weisen eine Aussparung auf, in welcher ein Mikrochip 10 montiert ist. Der Mikrochip 10 ist mit seiner metallisierten Unterseite 46 an der Unterseite der Substratschicht 48 montiert. Der Mikrochip 10 ist mittels Bonddrähten 12 auf seiner Oberseite mit der Unterseite der Substratschicht 42 verbunden. Ebenso ist eine Verbindung des Mikrochips durch eine Kugelgitteranordnung (Ball Grid Array) oder Wende-Montage (Flip-Chip) möglich.

Die Aussparung, in welcher der Mikrochip 10 montiert ist, ist mittels der Abdeckung 45 hermetisch dicht verschlossen. Ebenso ist eine Abdeckung mit nichtleitendem Füllmaterial (junction coating) möglich. In dem Mikrochip 10 entstehende Wärme wird über die thermischen Durchverbindungen 44 an die Oberseite des mehrschichtigen Substrats 47 geleitet, dort von einem Wärme leitenden Abstandshalter 41 an einen Kühlkörper 40 transportiert und von diesem abgestrahlt. Der Abstandshalter 41 ist dabei schmaler ausgeführt als der Kühlkörper 40. Dies dient dem Gewinn von mit Bauteilen bestückbarer Oberfläche der mehrschichtigen Substrats 47. Ebenso ist der Einsatz mehrerer Abstandshalter 41 an unterschiedlichen Positionen des mehrschichtigen Substrats 47, z.B. über weiteren Mikrochips oder anderen Wärme abstrahlenden Bauteilen denkbar. Auch eine Kombination des Abstandshalter 41 und des Kühlkörpers 40 in einem Bauteil ist möglich. Dies erfolgt z.B. durch Strukturierung der Rückseite des Kühlkörpers 40. Bei der Auswahl des Materials des Abstandshalters und des Kühlkörpers ist auf die thermische Ausdehnung zu achten, um mechanische Spannungen und eine daraus folgende Ablösung zu vermeiden. Durch eine Schraubverbindung kann die Gefahr der Ablösung trotz unterschiedlicher thermischer Ausdehnungskoeffizienten vermieden werden. Durch die Reduktion der für die Kühlung notwendigen Fläche durch den Abstandshalter können zusätzliche Bauelemente 13 auf der Oberfläche des Substrats 47 montiert werden. Das mehrschichtige Substrat 47 ist mittels der Durchverbindungen 49 über eine Kugelgitteranordnung (Ball Grid Array) 17 mit einer die elektronische Schaltungsanordnung tragenden Leiterplatte 16 elektrisch verbunden. Durch die sehr kurze und gerichtete Wärmeleitung tritt nur eine geringe Wärmemenge in das mehrschichtige Substrat 47 und in die Leiterplatte 16 ein. Auf der Oberseite der das mehrlagige Substrat 47 tragenden Leiterplatte 16 ist eine metallisierte Schicht 51 aufgebracht. Diese ist lediglich durch die Kontakte z.B. der Kugelgitteranordnung 17 unterbrochen. Die fast vollständige Metallisierung der Oberfläche bewirkt eine Abschirmung. In Fig. 3 ist lediglich ein Teil der Metallisierten Schicht 51 dargestellt, um die Erkennbarkeit der Kugelgitteranordnung 17 zu gewährleisten.

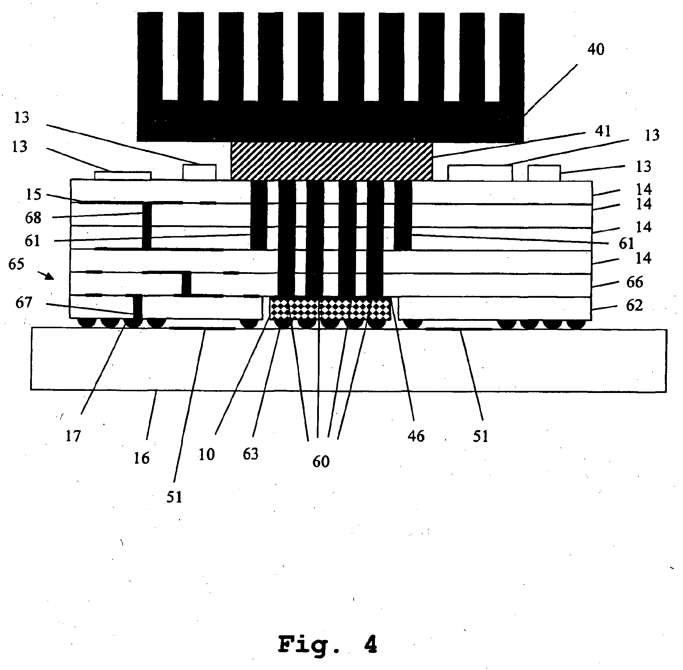

Fig. 4 zeigt eine zweite beispielhafte erfindungsgemäße elektronische Schaltungsanordnung in seitlicher Schnittdarstellung. Ein mehrschichtiges Substrat 65, hier eine mehrschichtige Keramik, besteht aus einzelnen Substratschichten 14, 62, 66. Auf den einzelnen Schichten 14, 62, 66 des mehrschichtigen Substrats 65 sind planare Leiterbahnen 15 aufgebracht, welche verschiedene Bauelemente bilden. So sind auch hier z.B. Widerstände, Kapazitäten, Induktivitäten, Filter, Koppler und viele weitere möglich. Die einzelnen Substratschichten 14, 62, 66 sind zum Teil mittels elektrischer Durchverbindungen 68 miteinander verbunden. Auf der Oberseite des mehrschichtigen Substrats sind oberflächenmontierte Bauelemente (Surface Mounted Devices) 13 montiert. Die Substratschicht 62 weist eine Aussparung auf, in welcher ein Mikrochip 10 montiert ist. Der Mikrochip 10 ist mit seiner metallisierten Unterseite 46 an der Unterseite der Substratschicht 66 montiert. Das mehrschichtige Substrat 65 ist mittels der Durchverbindungen 67 über eine Kugelgitteranordnung (Ball Grid Array) 17 mit einer, die elektronische Schaltungsanordnung tragenden Leiterplatte 16 elektrisch verbunden. Die Oberseite des Mikrochips 10 ist bündig mit der Unterseite der Substratschicht 62 und ebenfalls mittels einer Kugelgitteranordnung (Ball Grid Array) 63 mit der Leiterplatte 16 verbunden. In dem Mikrochip 10 entstehende Wärme wird über die thermischen Durchverbindungen 60, 61 an die Oberfläche des mehrschichtigen Substrats 65 geleitet, dort von einem Wärme leitenden Abstandshalter 41 an einen Kühlkörper 40 transportiert und von diesem abgestrahlt. Die thermischen Durchverbindungen 61 erstrecken sich lediglich in höheren Substratschichten, um der Ausbreitungscharakteristik der im Mikrochip 10 entstehenden Wärme in dem mehrschichtigen Substrat 65 Rechnung zu tragen. Durch die sehr kurze und gerichtete Wärmeleitung tritt nur eine geringe Wärmemenge in das mehrschichtige Substrat 47 und in die Leiterplatte 16 ein. Durch die Nachbildung der Ausbreitungscharakteristik der Wärme in dem mehrschichtigen Substrat 65 wird der Wärmeeintrag in das mehrschichtige Substrat 65 weiter reduziert und damit die Kühlung verbessert (Reduktion des thermischen Widerstands zum Kühlkörper). Auf der Oberseite der das mehrlagige Substrat 65 tragenden Leiterplatte 16 ist eine metallisierte Schicht 51 aufgebracht. Diese ist lediglich durch die Kontakte z.B. der Kugelgitteranordnung 17 unterbrochen. Die fast vollständige Metallisierung der Oberfläche bewirkt eine Abschirmung. In Fig. 4 ist lediglich ein Teil der Metallisierten Schicht 51 dargestellt, um die Erkennbarkeit der Kugelgitteranordnung 17 zu gewährleisten.

Die Erfindung ist nicht auf das dargestellte Ausführungsbeispiel beschränkt. Wie bereits erwähnt, können unterschiedliche mehrlagige Substrate eingesetzt werden. Ebenfalls ist die Integration beliebiger planarer Bauelemente auf den einzelnen Lagen des Substrats möglich. Auch ein Einsatz von integrierten Schaltungen, die von Mikrochips abweichen, ist denkbar. So könnte beispielsweise ein Bauteil in einem eigenen Gehäuse mit Wärme-Verteiler auf der Gehäuseunterseite und direktem Kontakt zu den thermischen Durchkontaktierungen eingesetzt werden. Alle vorstehend beschriebenen Merkmale oder in den Figuren gezeigten Merkmale sind im Rahmen der Erfindung beliebig miteinander kombinierbar.

## Patentansprüche

1. Elektronische Schaltungsanordnung mit
(a) einer Trägerplatine (16),
(b) einem mehrlagigen Substrat (47, 65), das mit seiner Unterseite auf der Trägerplatine (16) angeordnet ist,
(c) zumindest einer Aussparung in zumindest einer Lage Substrats (47, 65) an dessen Unterseite,
(d) zumindest einem Wärme abstrahlenden Bauelement (10), das an der Unterseite des Substrats (47, 65) in der Ausnehmung angeordnet ist,
(e) zumindest einem an der Oberseite des Substrats (47, 65) angeordneten Kühlelement (40),
(f) einem Abstandshalter (41) zwischen dem Kühlelement (40) und der Oberseite des Substrats (47, 65), wobei die Querschnittsfläche des Abstandshalters (41) kleiner als die des Kühlelementes (10) ist,
(g) zumindest einer das Substrat (47, 65) vollständig durchgreifenden Durchkontaktierung (44, 60), die das Wärme abstrahlende Bauelement (10) mit dem Kühlelement (40) verbindet, und
(h) einer elektrischen Verbindung des mehrlagigen Substrats (47, 65) mit der Trägerplatine (16).

2. Elektronische Schaltungsanordnung nach Anspruch 1,
**dadurch gekennzeichnet,**
**dass** das Wärme abstrahlende Bauelement (10) ein Mikrochip ist.

3. Elektronische Schaltungsanordnung nach Anspruch 1 oder 2,
**dadurch gekennzeichnet,**
**dass** das Wärme abstrahlende Bauelement (10) mittels mehrerer thermischer Durchkontaktierungen (60, 61) mit dem Kühlelement (40) verbunden ist,
**dass** zumindest eine der mehreren thermischen Durchkontaktierungen (60, 61) nicht durch sämtliche Lagen (14, 62, 66) des mehrlagigen Substrats (65) geführt ist, und
**dass** die Verteilung der mehreren thermischen Durchkontaktierungen (60, 61) in ihrer Position und in der Anzahl an Lagen (14, 62, 66) des mehrlagigen Substrats (65), durch welche die mehreren thermischen Durchkontaktierungen (60, 61) geführt sind, die Verbreitungscharakteristik der von dem Wärme abstrahlenden Bauelement (10) abgestrahlten Wärme nachbildet.

4. Elektronische Schaltungsanordnung nach einem der Ansprüche 1 bis 3,
**dadurch gekennzeichnet,**
**dass** das mehrlagige Substrat (47, 65) durch mehrere Lagen (14, 42, 43, 62, 66) eines keramischen Werkstoffs gebildet ist.

5. Elektronische Schaltungsanordnung nach einem der Ansprüche 1 bis 3,
**dadurch gekennzeichnet,**
**dass** das mehrlagige Substrat (47, 65) durch eine mehrlagige Leiterplatte gebildet ist.

6. Elektronische Schaltungsanordnung nach einem der Ansprüche 1 bis 5,
**dadurch gekennzeichnet,**
**dass** auf der Oberseite des mehrlagigen Substrats (47, 65) zumindest ein oberflächenmontiertes Bauelement (Surface Mounted Device) (13) montiert ist.

7. Elektronische Schaltungsanordnung nach einem der Ansprüche 1 bis 6,
**dadurch gekennzeichnet,**
**dass** das zumindest eine Wärme abstrahlende Bauelement (10) über eine metallisierte Fläche (46) zur Anbindung an die zumindest eine thermische Durchkontaktierung (44, 60, 61) verfügt.

8. Elektronische Schaltungsanordnung nach einem der Ansprüche 1 bis 7,
**dadurch gekennzeichnet,**
**dass** das zumindest eine Kühlelement ein Kühlkörper (40) oder ein Kühlblech oder ein Schirmdeckel ist.

9. Elektronische Schaltungsanordnung nach Anspruch 8, **dadurch gekennzeichnet,**
**dass** die Verbindung des Abstandshalters (41) an das Kühlelement durch Wärmeleitpaste oder Wärmematten oder durch direkten Kontakt oder durch eine feste Verbindung durch Löten oder durch eine feste Verbindung durch Kleben oder durch Aufpressen oder durch Schrauben oder durch Fertigung aus einem gemeinsamen Werkstück erfolgt, und dass die Verbindung der zumindest einen thermischen Durchkontaktierung (44, 60, 61) zu dem zumindest einen Abstandshalter (41) durch Wärmeleitpaste oder Wärmematten oder durch direkten Kontakt oder durch eine feste Verbindung durch Löten oder durch eine feste Verbindung durch Kleben oder durch Aufpressen oder durch Schrauben erfolgt.

10. Elektronische Schaltungsanordnung nach einem der Ansprüche 1 bis 9,
**dadurch gekennzeichnet,**
**dass** auf zumindest einer Lage (14, 25, 31, 42, 43, 62, 66) des mehrlagigen Substrats (20, 30, 47, 65) zumindest ein planares Bauelement (15) integriert ist, und
**dass** das zumindest eine planare Bauelement (15) eine Kapazität und/oder ein Widerstand und/oder eine Induktivität und/oder ein Koppler und/oder ein Filter ist.

11. Elektronische Schaltungsanordnung nach einem der Ansprüche 1 bis 10,
**dadurch gekennzeichnet,**
**dass** das mehrlagige Substrat (20,30,47,65) über eine Kugelgitteranordnung (Ball Grid Array) (17) oder eine Flächengitteranordnung (Land Grid Array) auf seiner Unterseite verfügt, und
**dass** das mehrlagige Substrat (20,30,47,65) mittels der Kugelgitteranordnung (Ball Grid Array) (17) bzw. Flächengitteranordnung (Land Grid Array) mit der die Trägerplatine (16) kontaktiert ist.

12. Elektronische Schaltungsanordnung nach einem der Ansprüche 1 bis 11,
**dadurch gekennzeichnet,**
**dass** das zumindest eine Wärme abstrahlende Bauelement (10) mittels einer Kugelgitteranordnung (Ball Grid Array) (63) oder einer Flächengitteranordnung (Land Grid Array) direkt mit einer Trägerplatine (16) kontaktiert ist.

13. Elektronische Schaltungsanordnung nach einem der Ansprüche 1 bis 11,
**dadurch gekennzeichnet,**
**dass** das zumindest eine Wärme abstrahlende Bauelement (10) mittels Kontaktierhügeln (Bumps) mit dem mehrlagigen Substrats (20, 30, 47, 65) kontaktiert ist.

14. Elektronische Schaltungsanordnung nach einem der Ansprüche 1 bis 13,
**dadurch gekennzeichnet,**
**dass** durch den äußeren Rand des mehrlagigen Substrats (20, 30, 47, 65) mehrere elektrische Durchkontaktierungen geführt sind,
**dass** sich zumindest zwischen zwei Lagen (14, 25, 31, 42, 43, 62, 66) des mehrlagigen Substrats zumindest eine metallisierte Massefläche befindet.

15. Elektronische Schaltungsanordnung nach einem der Ansprüche 1 bis 13,
**dadurch gekennzeichnet,**
**dass** die zumindest eine thermische Durchkontaktierung (44, 60, 61) als Aussparung in zumindest einer Lage des mehrlagigen Substrats (20, 30, 47, 65) realisiert ist, dass die Seitenflächen der Aussparung mit einem Wärme leitenden Material beschichtet sind, und
**dass** die Aussparung nicht vollständig mit dem Wärme leitenden Material gefüllt ist.

16. Elektronische Schaltungsanordnung nach einem der Ansprüche 1 bis 14,
**dadurch gekennzeichnet,**
**dass** die zumindest eine thermische Durchkontaktierung (44, 60, 61) als Aussparung in zumindest einer Lage des mehrlagigen Substrats (20, 30, 47, 65) realisiert ist, dass die Aussparung vollständig mit dem Wärme leitenden Material gefüllt ist.

17. Elektronische Schaltungsanordnung nach einem der Ansprüche 1 bis 16,
**dadurch gekennzeichnet,**
**dass** die zumindest eine thermische Durchkontaktierung (44, 60, 61) aus einem elektrisch leitfähigen Material besteht, und
**dass** die zumindest eine thermische Durchkontaktierung (44, 60, 61) zur Übertragung von elektrischer Spannung bzw. elektrischem Strom eingesetzt ist.

## Claims

1. Electronic circuit arrangement with
(a) a carrier circuit board (16),
(b) a multi-layer substrate (47, 65) which is arranged with its underside on the carrier circuit board (16),
(c) at least one opening in at least one layer of the substrate (47, 65) on its underside,
(d) at least one heat-radiating component (10) which is arranged on the underside of the substrate (47, 65) in the opening,
(e) at least one cooling element (40) arranged on the upper side of the substrate (47, 65),
(f) a spacer (41) between the cooling element (40) and the upper side of the substrate (47, 65), wherein the cross-sectional area of the spacer (41) is less than that of the cooling element (40),
(g) at least one feed through (44, 60) which passes completely through the substrate (47, 65) and connects the heat-radiating component (10) with the cooling element (40), and
(h) an electrical connection of the multi-layer substrate (47, 65) with the carrier circuit board (16).

2. Electronic circuit arrangement according to claim 1, **characterised in that**
the heat-radiating component (10) is a microchip.

3. Electronic circuit arrangement according to claim 1 or 2,
**characterised in that**
the heat-radiating component (10) is connected with the cooling element (40) by means of a plurality of thermal feed throughs (60, 61),
**in that** at least one of the plurality of thermal feed throughs (60, 61) is not passed through all the layers (14, 62, 66) of the multi-layer substrate (65), and
**in that** the distribution of the plurality of thermal feed throughs (60, 61) in their position and in the number of layers (14, 62, 66) of the multi-layer substrate (65) through which the plurality of thermal feed throughs (60, 61) are passed, matches the propagation characteristic of the heat radiated by the heat-radiating component (10).

4. Electronic circuit arrangement according to one of claims 1 to 3,
**characterised in that**
the multi-layer substrate (47, 65) is formed by a plurality of layers (14, 42, 43, 62, 66) of a ceramic material.

5. Electronic circuit arrangement according to one of claims 1 to 3,
**characterised in that**
the multi-layer substrate (47, 65) is formed by a multi-layer printed circuit board.

6. Electronic circuit arrangement according to one of claims 1 to 5,
**characterised in that**
at least one surface-mounted device (13) is mounted on the upper side of the multi-layer substrate (47, 65).

7. Electronic circuit arrangement according to one of claims 1 to 6,
**characterised in that**
the at least one heat-radiating component (10) has a metallised face (46) for attachment to the at least one thermal feed through (44, 60, 61).

8. Electronic circuit arrangement according to one of claims 1 to 7,
**characterised in that**
the at least one cooling element is a heat sink (40) or a cooling plate or a shielding cover.

9. Electronic circuit arrangement according to claim 8, **characterised in that**
the connection of the spacer (41) to the cooling element is effected by heat-conducting paste or thermal mats or by direct contact or by a fixed connection by soldering or by a fixed connection by gluing or by pressing on or by screwing or by production from a common workpiece, and **in that** the connection of the at least one thermal feed through (44, 60, 61) to the at least one spacer (41) is effected by heat-conducting paste or thermal mats or by direct contact or by a fixed connection by soldering or by a fixed connection by gluing or by pressing on or by screwing.

10. Electronic circuit arrangement according to one of claims 1 to 9,
**characterised in that**
at least one planar component (15) is integrated on at least one layer (14, 25, 31, 42, 43, 62, 66) of the multi-layer substrate (20, 30, 47, 65), and
**in that** the at least one planar component (15) is a capacitor and/or a resistor and/or an inductor and/or a coupler and/or a filter.

11. Electronic circuit arrangement according to one of claims 1 to 10,
**characterised in that**
the multi-layer substrate (20, 30, 47, 65) has a ball grid array (17) or a land grid array on its underside, and
**in that** the multi-layer substrate (20, 30, 47, 65) is in contact with the carrier circuit board (16) by means of the ball grid array (17) or land grid array.

12. Electronic circuit arrangement according to one of claims 1 to 11,
**characterised in that**
the at least one heat-radiating component (10) is in direct contact with a carrier circuit board (16) by means of a ball grid array (63) or a land grid array.

13. Electronic circuit arrangement according to one of claims 1 to 11,
**characterised in that**
the at least one heat-radiating component (10) is in contact with the multi-layer substrate (20, 30, 47, 65) by means of contact bumps.

14. Electronic circuit arrangement according to one of claims 1 to 13,
**characterised in that**
a plurality of electrical feed throughs are passed through the outer edge of the multi-layer substrate (20, 30, 47, 65),
**in that** at least one metallised grounding face is located at least between two layers (14, 25, 31, 42, 43, 62, 66) of the multi-layer substrate.

15. Electronic circuit arrangement according to one of claims 1 to 13,
**characterised in that**
the at least one thermal feed through (44, 60, 61) is produced in the form of an opening in at least one layer of the multi-layer substrate (20, 30, 47, 65),
**in that** the side faces of the opening are coated with a heat-conducting material, and
**in that** the opening is not completely filled with the heat-conducting material.

16. Electronic circuit arrangement according to one of claims 1 to 14,
**characterised in that**
the at least one thermal feed through (44, 60, 61) is produced in the form of an opening in at least one layer of the multi-layer substrate (20, 30, 47, 65), and
**in that** the opening is completely filled with the heat-conducting material.

17. Electronic circuit arrangement according to one of claims 1 to 16,
**characterised in that**
the at least one thermal feed through (44, 60, 61) is made of an electrically conductive material, and
**in that** the at least one thermal feed through (44, 60, 61) is used to transmit electrical voltage or electrical current.

## Revendications

1. Circuit de commutation électronique comportant
(a) une plaque de support (16),
(b) un substrat multicouche (47, 65), qui est disposé avec son côté inférieur sur la plaque de support (16),
(c) au moins un évidement dans au moins une couche du substrat (47, 65) sur son côté inférieur,
(d) au moins un composant rayonnant de la chaleur (10), qui est disposé dans un évidement sur le côté inférieur du substrat (47, 65),
(e) au moins un élément de refroidissement (40) disposé sur le côté supérieur du substrat (47, 65),
(f) un élément d'écartement (41) entre l'élément de refroidissement (40) et le côté supérieur du substrat (47, 65), dans lequel la surface en coupe de l'élément d'écartement (41) est plus petite que celle de l'élément de refroidissement (10),
(g) au moins un contact traversant (44, 60) traversant complètement le substrat (47, 65), qui relie le composant émettant de la chaleur (10) à l'élément de refroidissement (40), et
(h) une liaison électrique du substrat multicouche (47, 65) avec la plaque de support (16).

2. Circuit de commutation électronique selon la revendication 1, **caractérisé en ce que**
le composant émettant de la chaleur (10) est une micro puce.

3. Circuit de commutation électronique selon la revendication 1 ou 2, **caractérisé en ce que**
le composant émettant de la chaleur (10) est relié à l'élément de refroidissement (40) au moyen de plusieurs contacts traversants thermiques (60, 61)
**en ce qu'**au moins l'un de la pluralité de contacts traversants thermiques (60, 61) n'est pas guidé à travers toutes les couches (14, 62, 66) du substrat multicouche (65), et
**en ce que** la répartition de la pluralité de contacts traversants thermiques (60, 61) dans leur position et dans la pluralité de couches (14, 62, 66) du substrat multicouche (65), grâce auxquels la pluralité de contacts traversants thermiques (60, 61) sont guidés, reproduit la caractéristique d'étalement de la chaleur rayonnée par le composant émettant de la chaleur (10).

4. Circuit de commutation électronique selon l'une des revendications 1 à 3, **caractérisé en ce que**
le substrat multicouche (47, 65) est formé par plusieurs couches (14, 42, 43, 62, 66) d'un matériau céramique.

5. Circuit de commutation électronique selon l'une des revendications 1 à 3, **caractérisé en ce que**
le substrat multicouche (47, 65) est formé par une carte de circuits imprimés multicouche.

6. Circuit de commutation électronique selon l'une des revendications 1 à 5, **caractérisé en ce que**
au moins un composé monté en surface (Surface Mounted Device) (13) est monté sur le côté supérieur du substrat multicouche (47, 65).

7. Circuit de commutation électronique selon l'une des revendications 1 à 6, **caractérisé en ce que**
le au moins un composant émettant de la chaleur (10) comporte une surface métallisée (46) en vue d'une liaison à au moins un contact traversant thermique (44, 60, 61).

8. Circuit de commutation électronique selon l'une des revendications 1 à 7, **caractérisé en ce que**
le au moins un élément de refroidissement est un dissipateur thermique (40) ou une tôle de refroidissement ou un couvercle blindé.

9. Circuit de commutation électronique selon la revendication 8, **caractérisé en ce que**
la liaison de l'élément d'écartement (41) est effectuée grâce à une pâte thermo-conductrice ou une natte chauffante ou par contact direct ou par une liaison fixe par soudage ou par une liaison fixe par collage ou par pressage ou par vissage ou par fabrication à partir d'une pièce à usiner commune, et
**en ce que** la liaison du au moins un contact traversant thermique (44, 60, 61) sur le au moins un élément d'écartement (41) est effectuée grâce à une pâte thermo-conductrice ou une natte chauffante ou par contact direct ou par une liaison fixe par soudage ou par une liaison fixe par collage ou par pressage ou par vissage.

10. Circuit de commutation électronique selon l'une des revendications 1 à 9, **caractérisé en ce que**
au moins un composant planaire (15) est intégré sur au moins une couche (14, 25, 31, 42, 43, 62, 66) du substrat multicouche (20, 30, 47, 65), et
**en ce que** le au moins un composant planaire (15) est une capacité et/ou une résistance et/ou un inducteur et/ou un coupleur et/ou un filtre.

11. Circuit de commutation électronique selon l'une des revendications 1 à 10, **caractérisé en ce que**
le substrat multicouche (20, 30, 47, 65) comporte une matrice de billes (Ball Grid Array) (17) ou une matrice de pastilles (Land Grid Array) sur son côté inférieur, et
**en ce que** le substrat multicouche (20, 30, 47, 65) est en contact de la plaque de support (16) grâce à la matrice de billes (Ball Grid Array) (17) ou grâce à la matrice de pastilles (Land Grid Array).

12. Circuit de commutation électronique selon l'une des revendications 1 à 11, **caractérisé en ce que**
le au moins un composant émettant de la chaleur (10) est en contact direct de la plaque de support (16) grâce à une matrice de billes (Ball Grid Array) (63) ou grâce à une matrice de pastilles (Land Grid Array).

13. Circuit de commutation électronique selon l'une des revendications 1 à 11, **caractérisé en ce que**
le au moins un composant émettant de la chaleur (10) est en contact du substrat multicouche (20, 30, 47, 65) grâce à des bosses de contact (Bumps).

14. Circuit de commutation électronique selon l'une des revendications 1 à 13, **caractérisé en ce que**
plusieurs contacts traversants électriques sont guidés à travers le bord extérieur du substrat multicouche (20, 30, 47, 65),
**en ce qu'**au moins une surface de masse métallisée se trouve au moins entre deux couches (14, 25, 31, 42, 43, 62, 66) du substrat multicouche.

15. Circuit de commutation électronique selon l'une des revendications 1 à 13, **caractérisé en ce que**
le au moins un contact traversant thermique (44, 60, 61) est réalisé sous la forme d'un évidement dans au moins une couche du substrat multicouche (20, 30, 47, 65),
**en ce que** les surfaces latérales de l'évidement sont revêtues d'un matériau thermo-conducteur, et
**en ce que** l'évidement n'est pas rempli complètement d'un matériau thermo-conducteur.

16. Circuit de commutation électronique selon l'une des revendications 1 à 14, **caractérisé en ce que**
le au moins un contact traversant thermique (44, 60, 61) est réalisé sous la forme d'un évidement dans au moins une couche du substrat multicouche (20, 30, 47, 65),
**en ce que** l'évidement est rempli complètement du matériau thermo-conducteur.

17. Circuit de commutation électronique selon l'une des revendications 1 à 16, **caractérisé en ce que**
le au moins un contact traversant thermique (44, 60, 61) est constitué d'un matériau électriquement conducteur, et
**en ce que** le au moins un contact traversant thermique (44, 60, 61) est inséré en vue de la transmission d'une tension électrique ou d'un courant électrique.
